(19) **Europäisches Patentamt / European Patent Office / Office européen des brevets**

(11) **EP 4 685 125 A1**

(12) **EUROPEAN PATENT APPLICATION**
published in accordance with Art. 153(4) EPC

(43) Date of publication:
**28.01.2026 Bulletin 2026/05**

(21) Application number: **24774957.5**

(22) Date of filing: **21.03.2024**

(51) International Patent Classification (IPC):
**C04B 35/581** (2006.01)  **H01L 23/02** (2006.01)
**H01L 23/13** (2006.01)

(52) Cooperative Patent Classification (CPC):
**C04B 35/581; H01L 23/02; H01L 23/13**

(86) International application number:
**PCT/JP2024/011027**

(87) International publication number:
**WO 2024/195823 (26.09.2024 Gazette 2024/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.03.2023 JP 2023046515**

(71) Applicant: **Kyocera Corporation**
**Kyoto-shi, Kyoto 612-8501 (JP)**

(72) Inventors:
• **HANASAKA, Fumihiro**
  **Kyoto-shi, Kyoto 612-8501 (JP)**
• **TOKUDOME, Masataka**
  **Kyoto-shi, Kyoto 612-8501 (JP)**
• **MAKIHARA, Yuuta**
  **Kyoto-shi, Kyoto 612-8501 (JP)**
• **IRIGUCHI, Masashi**
  **Kyoto-shi, Kyoto 612-8501 (JP)**
• **KIRIKIHIRA, Isamu**
  **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **ALUMINUM NITRIDE SINTERED COMPACT, SUBSTRATE, ELECTRONIC DEVICE, AND ELECTRONIC MODULE**

(57)    An aluminum nitride sintered body includes a plurality of crystal grains containing aluminum nitride as a main component. The plurality of crystal grains includes, in cross section, a first crystal grain, a second crystal grain adjacent to the first crystal grain, a third crystal grain adjacent to the first crystal grain and the second crystal grain, and a grain boundary located between all or any two of the first crystal grain, the second crystal grain, and the third crystal grain. In cross section, the grain boundary has a minimum thickness of 0.2 nm or more and 0.7 nm or less.

FIG. 4

EP 4 685 125 A1

**Description**

TECHNICAL FIELD

The present disclosure relates to an aluminum nitride sintered body, a substrate, an electronic device, and an electronic module.

BACKGROUND OF INVENTION

International Publication No. 2005/049525 describes an aluminum nitride sintered body having improved bending strength.

SUMMARY

SOLUTION TO PROBLEM

According to the present disclosure, an aluminum nitride sintered body includes:
a plurality of crystal grains containing aluminum nitride as a main component.
The plurality of crystal grains includes,
in cross section, a first crystal grain, a second crystal grain adjacent to the first crystal grain, a third crystal grain adjacent to the first crystal grain and the second crystal grain, and a grain boundary located between all or any two of the first crystal grain, the second crystal grain, and the third crystal grain.
In cross section, the grain boundary has a minimum thickness of 0.2 nm or more and 0.7 nm or less.
According to the present disclosure, a substrate includes:

the above-described aluminum nitride sintered body having a first surface; and
a mounting portion for an electronic element, the mounting portion being located at the first surface.

According to the present disclosure, an electronic device includes:

the above-described substrate; and
an electronic element mounted on the mounting portion.

According to the present disclosure, an electronic module includes:

the above-described electronic device; and
a module substrate on which the electronic device is mounted.

ADVANTAGEOUS EFFECT

The present disclosure provides an aluminum nitride sintered body having improved thermal conductivity and improved mechanical strength, a substrate, an electronic device including the substrate, and an electronic module including the substrate.

BRIEF DESCRIPTION OF THE DRAWINGS

FIG. 1 is an enlarged view of a cross section of an aluminum nitride sintered body according to Embodiment 1 of the present disclosure.
FIG. 2 illustrates a specific structure of the aluminum nitride sintered body of FIG. 1.
FIG. 3A is an image of a grain boundary of an aluminum nitride sintered body 1 of Embodiment 1.
FIG. 3B is an image of a grain boundary of an aluminum nitride sintered body of Comparative Example 1.
FIG. 4 is a graph showing the results of measurement of the thickness of a grain boundary of Embodiment 1 and the thickness of a grain boundary of Comparative Example 1.
FIG. 5 illustrates a specific structure of an aluminum nitride sintered body of Comparative Example 2.
FIG. 6 is an SEM image of a cross section of the aluminum nitride sintered body of Comparative Example 1.
FIG. 7A is a graph showing an area distribution of grain boundary phases that is determined in one of three regions of the aluminum nitride sintered body of Embodiment 1.

FIG. 7B is a graph showing an area distribution of grain boundary phases that is determined in another one of the three regions of the aluminum nitride sintered body of Embodiment 1.

FIG. 7C is a graph showing an area distribution of grain boundary phases that is determined in still another one of the three regions of the aluminum nitride sintered body of Embodiment 1.

FIG. 8A is a graph showing an area distribution of grain boundary phases that is determined in one of three regions of the aluminum nitride sintered body of Comparative Example 1.

FIG. 8B is a graph showing an area distribution of grain boundary phases that is determined in another one of the three regions of the aluminum nitride sintered body of Comparative Example 1.

FIG. 8C is a graph showing an area distribution of grain boundary phases that is determined in still another one of the three regions of the aluminum nitride sintered body of Comparative Example 1.

FIG. 9A is a graph showing an area distribution of grain boundary phases that is determined in one of three regions of an aluminum nitride sintered body of Embodiment 2.

FIG. 9B is a graph showing an area distribution of grain boundary phases that is determined in another one of the three regions of the aluminum nitride sintered body of Embodiment 1.

FIG. 9C is a graph showing an area distribution of grain boundary phases that is determined in still another one of the three regions of the aluminum nitride sintered body of Embodiment 1.

FIG. 10 is a graph showing the thermal conductivity and the bending strength of the aluminum nitride sintered body 1 of the present embodiment and a plurality of aluminum nitride sintered bodies disclosed in Patent Literature 1.

FIG. 11 illustrates a substrate, an electronic device, and an electronic module that are obtained using the aluminum nitride sintered body according to the present embodiment.

DESCRIPTION OF EMBODIMENTS

Hereinafter, embodiments of the present disclosure will be described in detail with reference to the drawings.

(Embodiment 1)

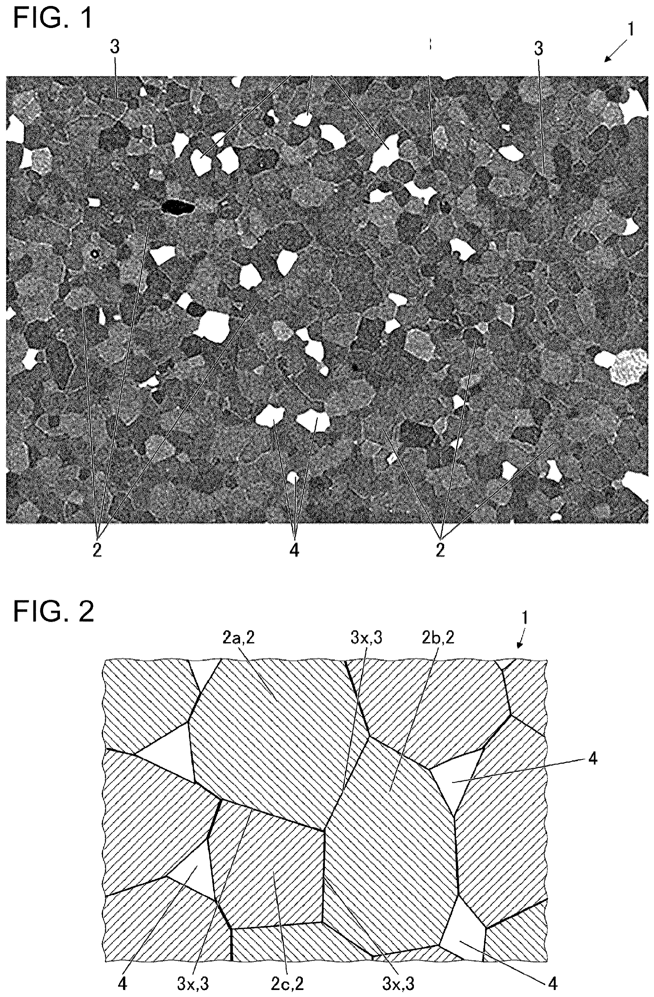

FIG. 1 is an enlarged view of a cross section of an aluminum nitride sintered body according to Embodiment 1 of the present disclosure. FIG. 2 illustrates a specific structure of the aluminum nitride sintered body of FIG. 1. FIG. 1 is an SEM (scanning electron microscope) image of the cross section.

In Embodiment 1, an aluminum nitride sintered body 1 is a ceramic containing AlN (aluminum nitride) as a main component. The main component means a component that accounts for 80 mass% or more. The aluminum nitride sintered body 1 may be produced in such a manner that a sintering aid and a binder are added to an AlN (aluminum nitride) raw material in the form of powder particles, the mixture is formed into a substrate, and then the substrate is debindered and fired in a furnace.

The aluminum nitride sintered body 1 includes a plurality of crystal grains 2, a grain boundary 3 located between the crystal grains 2 adjacent to each other, and a plurality of grain boundary phases 4 located between the crystal grains 2 adjacent to each other, as illustrated in FIG. 1 and FIG. 2. The grain boundary 3 is linear in a cross section of the aluminum nitride sintered body 1. "Linear" means a shape that is elongated in any direction such that the width perpendicular to the longitudinal direction is less than 50 nm. "Linear" is a concept including not only a straight shape but also a curved shape. The grain boundary phases 4 each include a two-dimensional region in a cross section of the aluminum nitride sintered body 1. "Two-dimensional region" means a region having widths of 100 nm or more in at least any two directions perpendicular to each other.

The crystal grains 2 are grains containing AlN as a main component.

The grain boundary 3 is a membranous structure including, as components, aluminum nitride, yttrium oxide, and an oxide containing aluminum and yttria.

The grain boundary phases 4 are each a composite of AlN and an oxide, and are each a liquid-phase substance. The grain boundary phases 4 may each contain at least yttrium and oxygen. Yttrium and oxygen may be present in the form of yttrium oxide.

<Specific Structure>

A description will be given focusing on three crystal grains 2a to 2c in a randomly selected cross section and a grain boundary 3x located therebetween, as illustrated in FIG. 2. The three crystal grains 2a to 2c are also referred to as a first crystal grain 2a, a second crystal grain 2b, and a third crystal grain 2c. The second crystal grain 2b is adjacent to the first crystal grain 2a, and the third crystal grain 2c is adjacent to the first crystal grain 2a and the second crystal grain 2b. The grain boundary 3x is located between all or any two of the first crystal grain 2a, the second crystal grain 2b, and the third crystal grain 2c.

<Minimum Thickness of Grain Boundary>

The minimum thickness of the grain boundary 3x may be 0.2 nm or more and 0.7 nm or less. This configuration improves thermal conductivity between the crystal grains 2a to 2c and improves bond strength of the crystal grains 2a to 2c.

The thickness of the grain boundary 3x can be measured in the following manner. Specifically, a cross section of the aluminum nitride sintered body 1 is processed with a CP (cross-section polisher), and the cross section is observed under a TEM (transmission electron microscope). Then, a TEM image of an area including the grain boundary 3x is obtained. In the TEM image, borders between the grain boundary 3x and the crystal grains 2 can be detected at high resolution. Therefore, the width in a direction perpendicular to the longitudinal direction of the grain boundary 3x, that is, the length from one border to the other border, can be measured as the thickness from the TEM image.

At a thickness of less than 0.2 nm, even a hydrogen molecule, which has the smallest excluded volume, can hardly exist, and it is theoretically difficult for a grain boundary 3x of less than 0.2 nm to exist. That is, a border portion of less than 0.2 nm in a border area between each crystal grain 2 and the outside is a portion distinct from the grain boundary 3x.

When the grain boundary 3x has a thickness of more than 0.7 nm, the proportion of a sintering aid component (e.g., yttrium oxide: $Y_2O_3$) that enters the grain boundary 3x significantly increases. The crystal of yttrium oxide ($Y_2O_3$) basically has a fluorite structure, in which 1/4 of sites where oxygen is desired to be located are vacancies. Accordingly, the structure is slightly distorted, but can be regarded as a six-coordinate octahedral structure from the perspective of molecular size. The bond distance from Y (yttrium atom) to O (oxygen atom) of yttrium oxide is 0.2312 nm. Thus, the theoretical minimum size of the grain boundary 3x that allows the entry of a molecule of yttrium oxide is estimated to be 0.6936 nm. Therefore, in view of the influence of various factors such as molecular vibration, the grain boundary 3x having a thickness of 0.7 nm or less can significantly reduce incorporation of yttrium oxide into the grain boundary 3x.

In addition to yttrium oxide, an oxide of a rare-earth element may be used as a sintering aid component. The rare-earth element may be at least one element selected from lanthanoids such as La (lanthanum), Ce (cerium), Pr (praseodymium), Nd (neodymium), Sm (samarium), Gd (gadolinium), Dy (dysprosium), Ho (holmium), Er (erbium), and Yb (ytterbium). Also when such a sintering aid is used, the grain boundary 3x having a thickness of 0.7 nm or less can significantly reduce incorporation of the sintering aid component into the grain boundary 3x on the same and/or similar principle.

When a sintering aid component and oxygen are contained in the grain boundary 3x, phonons tend to scatter in the grain boundary 3x, thus reducing thermal conductivity. When a sintering aid component and oxygen are contained in the grain boundary 3x, the bonding between the crystal grains 2a to 2c adjacent to each other is reduced, thus decreasing the mechanical strength for maintaining the bond between the crystal grains 2a to 2c.

Therefore, the grain boundary 3x having a minimum thickness of 0.2 nm or more and 0.7 nm or less excludes sintering aid components from a portion with the minimum thickness. Thus, high thermal conductivity and high mechanical strength between a pair of the crystal grains 2 are provided through the portion with the minimum thickness.

In a ceramic, a structure that is the same as, and/or similar to, that of a certain region is provided in many regions. Therefore, when the three crystal grains 2a to 2c are selected and the grain boundary 3x has a minimum thickness in the above-described range, the grain boundary 3 located in many other regions of the aluminum nitride sintered body 1 has the same and/or similar minimum thickness. Therefore, when the grain boundary 3x has a minimum thickness in the above-described range in a certain region, the grain boundary 3 having the same and/or similar minimum thickness is located also in many regions, and high thermal conductivity and high mechanical strength are provided throughout the aluminum nitride sintered body 1.

In the aluminum nitride sintered body 1, the grain boundary 3 may have a minimum thickness of 0.2 nm or more and 0.7 nm or less in any of at least 10 regions selected separately from each other.

<Average Thickness of Grain Boundary>

The thickness of the grain boundary 3x may be 0.2 nm or more and 0.7 nm or less on average.

It is difficult to obtain a TEM image of the entire circumference of one crystal grain 2. Therefore, the average thickness of the grain boundary 3x is calculated in the following manner. Specifically, a TEM image showing a crystal grain 2 and a surrounding grain boundary 3x is obtained in at least 10 randomly selected areas. Then, the thickness of the grain boundary 3x in each TEM image (i.e., the width in the image) is measured. Through the measurement, measured values of the thickness of the grain boundary 3x in the at least 10 randomly selected areas, that is, multiple measured values, are obtained. Then, the multiple measured values are arranged in descending order, and a certain percentage (i.e., 10% by number) of the measured values starting from the largest and a certain percentage (i.e., 10% by number) of the measured values starting from the smallest are removed. This is intended to remove abnormal values included in the measured values. Then, the multiple measured values left after the removal are averaged, and the calculated value is determined as the average thickness of the grain boundary 3x.

The grain boundary 3x having an average thickness in the above-described range can significantly reduce the entry of sintering aid components and oxygen over most of the grain boundary 3x. Accordingly, the aluminum nitride sintered body 1 can have significantly improved thermal conductivity and mechanical strength.

In the aluminum nitride sintered body 1, the grain boundary 3 may have an average thickness of 0.2 nm or more and 0.7 nm or less in any of at least 10 regions selected separately from each other.

<Specific Example of Thickness of Grain Boundary>

Specific examples of the grain boundary 3x of the aluminum nitride sintered body 1 of Embodiment 1 and a grain boundary 813 of an aluminum nitride sintered body 81 of Comparative Example 1 will be described.

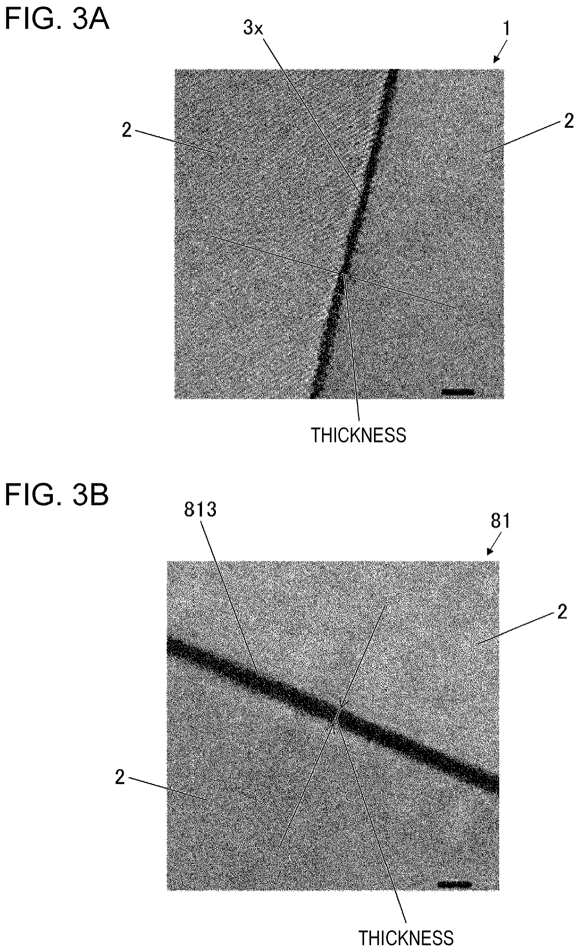

FIG. 3A is an image of the grain boundary 3x of the aluminum nitride sintered body 1 of Embodiment 1. FIG. 3B is an image of the grain boundary 813 of the aluminum nitride sintered body 81 of Comparative Example 1.

The minimum thickness of the grain boundary 3x of Embodiment 1 measured from FIG. 3A is 0.37 nm. The minimum thickness of the grain boundary 813 of Comparative Example 1 measured from FIG. 3B is 0.74 nm.

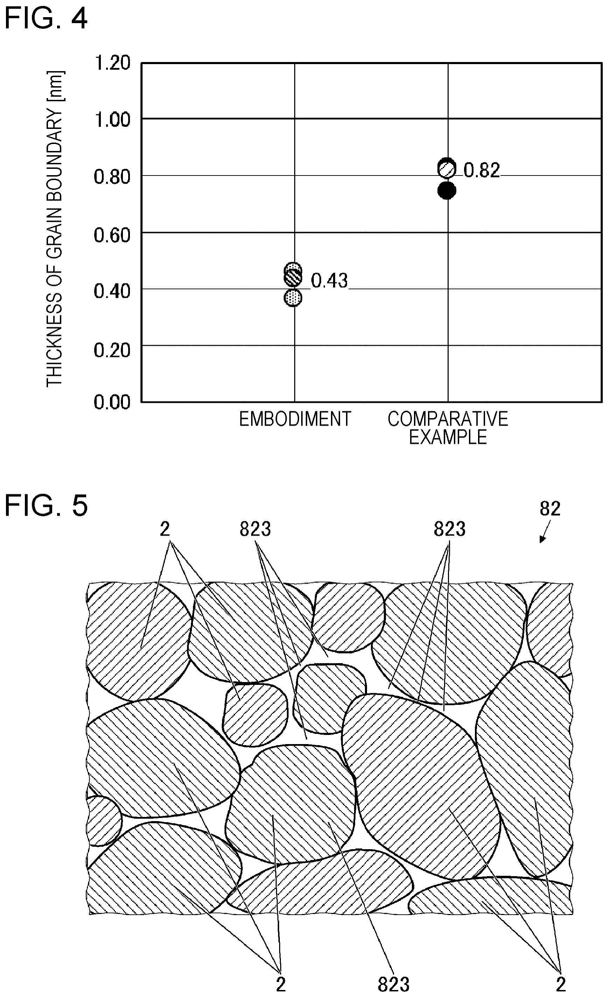

FIG. 4 is a graph showing the results of measurement of the thickness of the grain boundary 3x of Embodiment 1 and the thickness of the grain boundary 813 of Comparative Example 1. A plurality of points on the graph indicates measured values left after a certain percentage of measured values starting from the largest and the smallest have been removed from multiple measured values.

The average thickness of the grain boundary 3x of the aluminum nitride sintered body 1 of Embodiment 1 is 0.43 nm. The average thickness of the grain boundary 813 of the aluminum nitride sintered body 81 of Comparative Example 1 is 0.82 nm.

As a result of measurement of bending strength and thermal conductivity, the aluminum nitride sintered body 1 of Embodiment 1 was found to have a bending strength of 431 MPa and a thermal conductivity of 244 W/m·K. The aluminum nitride sintered body 81 of Comparative Example 1 was found to have a bending strength of 350 MPa and a thermal conductivity of 210 W/m·K. As described above, the aluminum nitride sintered body 1 of Embodiment 1 was found to be superior to the aluminum nitride sintered body 81 of Comparative Example 1 in both thermal conductivity and mechanical strength. Methods of measuring thermal conductivity and bending strength will be described later.

FIG. 5 illustrates a specific structure of an aluminum nitride sintered body 82 of Comparative Example 2. As illustrated in FIG. 5, in a configuration in which the crystal grains 2 are less dense so that each crystal grain 2 is rounded, the variation in thickness of a grain boundary 823 is large, and the grain boundary 823 has a very large average thickness. In such a configuration, very thick portions of the grain boundary 823 significantly reduce the thermal conductivity and mechanical strength of the aluminum nitride sintered body 82. Also in Comparative Example 2, the thickness of the grain boundary 823 varied widely, and it was difficult to achieve an appropriate thickness of the grain boundary 823.

<Distribution of Grain Boundary Phase>

In the aluminum nitride sintered body 1 of Embodiment 1, the grain boundary phases 4 may be segregated in cross section. "Segregated" means that the peak of an area distribution of the grain boundary phases 4 in cross section is located at 0.5 $\mu m^2$ or more. "Area distribution" refers to a frequency distribution of areas.

When the area distribution peak of the grain boundary phases 4 is located at a smaller area value, it means that smaller grain boundary phases 4 are distributed in greater amounts, and the spatial distribution of the grain boundary phases 4 becomes more uniform. On the other hand, when the area distribution peak of the grain boundary phases 4 is located at a larger area value, it means that smaller grain boundary phases 4 are distributed in lesser amounts, and the degree of unevenness of the spatial distribution of the grain boundary phases 4 becomes higher. The grain boundary phases 4 contain a sintering aid component and oxygen, and thus cause phonons to scatter, and reduce thermal conduction. Therefore, as the spatial distribution of the grain boundary phases 4 becomes more uniform, the thermal conductivity of the aluminum nitride sintered body decreases. On the other hand, when the degree of unevenness of the spatial distribution of the grain boundary phases 4 is high, regions where the grain boundary phases 4 are absent increase, thus improving the thermal conductivity of the aluminum nitride sintered body. Therefore, the segregation of the grain boundary phases 4 as described above can improve the thermal conductivity of the aluminum nitride sintered body 1.

The area distribution peak may be located at 0.5 $\mu m^2$ or more and 30 $\mu m^2$ or less. This configuration can increase regions where the grain boundary phases 4 are not located to improve the thermal conductivity of the aluminum nitride sintered body 1. The area distribution peak may be located at 0.8 $\mu m^2$ or more and 20 $\mu m^2$ or less. This configuration can further improve the thermal conductivity of the aluminum nitride sintered body 1. The area distribution peak may be at 1 $\mu m^2$ or more and 10 $\mu m^2$ or less. This configuration can further improve the thermal conductivity of the aluminum nitride sintered body 1.

The area distribution of the grain boundary phases 4 can be measured in the following manner. First, a cross section of the aluminum nitride sintered body 1 is subjected to colloidal polishing, and an SEM image of the cross section is obtained by SEM observation. Then, pixels of the SEM image are binarized using a threshold at which pixels of the grain boundary phases 4 and pixels of the crystal grains 2 are distinguishable from each other. The binarization can be carried out using image processing software "Image J (available from https://imagej.nih.gov/ij/index.html)". Then, all the grain boundary phases 4 are selected from the binarized image, and the areas of the grain boundary phases 4 are counted to obtain the frequency distribution.

<Specific Example of Distribution of Grain Boundary Phases>

Specific examples of the distribution of the grain boundary phases 4 of the aluminum nitride sintered body 1 of Embodiment 1 and the distribution of the grain boundary phases 4 of the aluminum nitride sintered body 81 of Comparative Example 1 will be described.

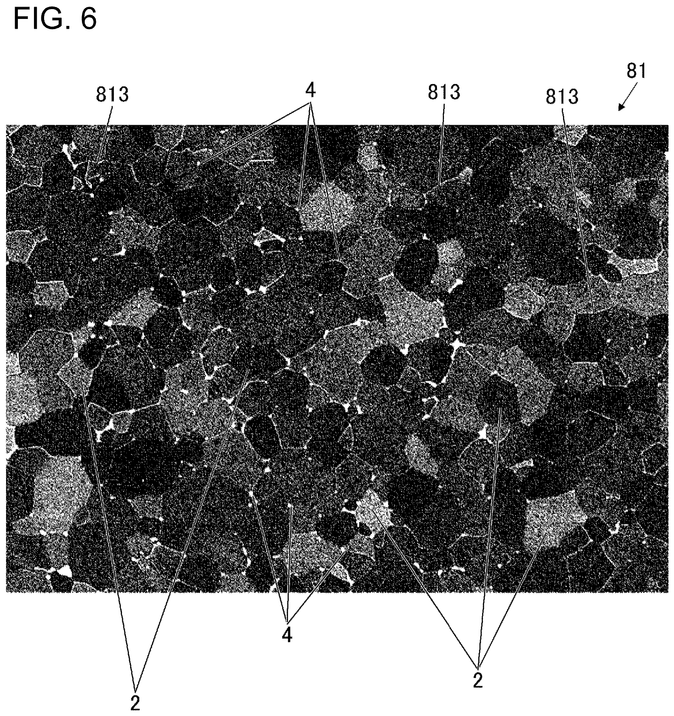

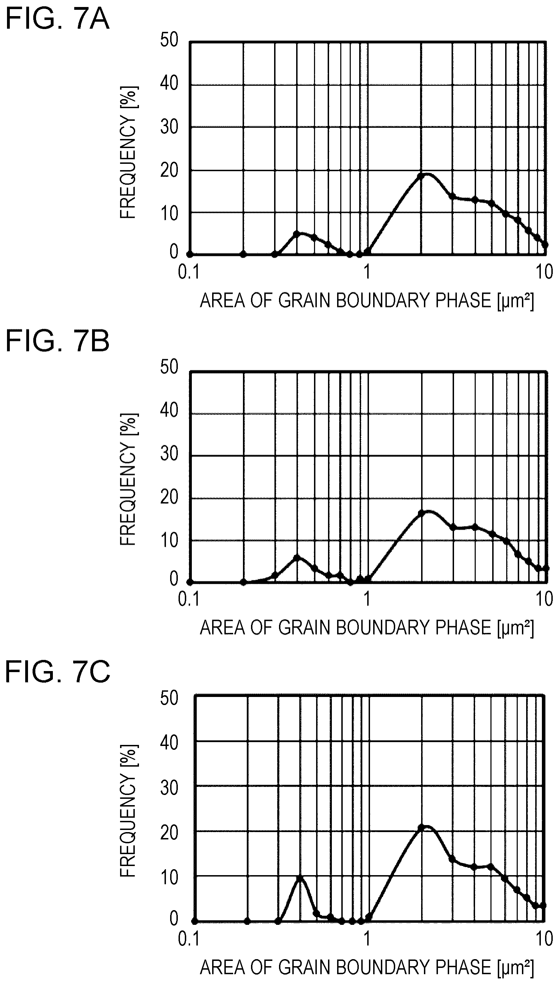

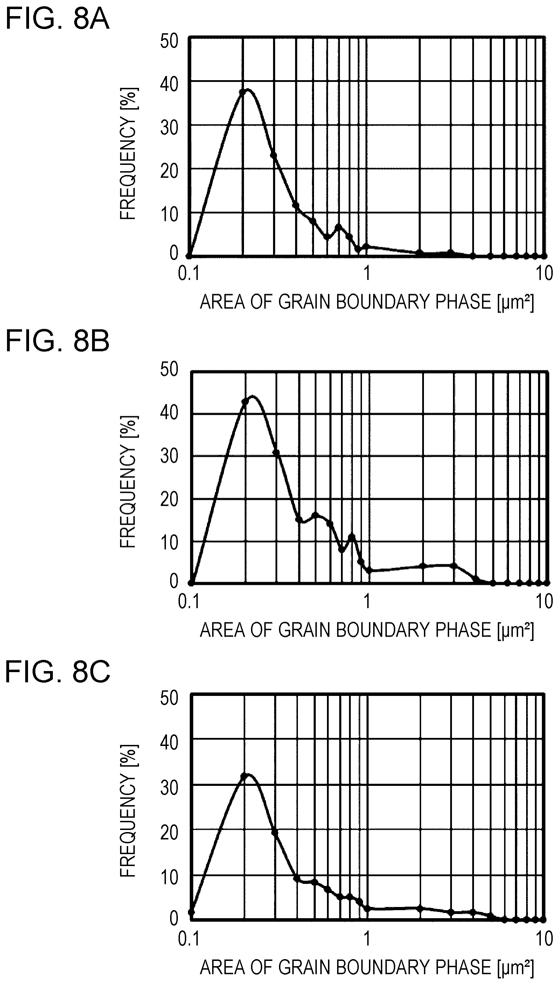

FIG. 6 is an SEM image of a cross section of the aluminum nitride sintered body of Comparative Example 1. FIG. 7A to FIG. 7C each illustrate an area distribution of grain boundary phases obtained from an SEM image of a cross section of the aluminum nitride sintered body 1 of Embodiment 1, and FIG. 8A to FIG. 8C each illustrate an area distribution of grain boundary phases obtained from an SEM image of a cross section of the aluminum nitride sintered body 81 of Comparative Example 1. FIG. 7A to FIG. 7C illustrate area distributions determined in three regions of the aluminum nitride sintered body 1 of Embodiment 1. FIG. 8A to FIG. 8C illustrate area distributions determined in three regions of the aluminum nitride sintered body 81 of Comparative Example 1.

The aluminum nitride sintered body 1 of Embodiment 1 has area distribution peaks near 2 $\mu m^2$. The aluminum nitride sintered body 81 of Comparative Example 1 has area distribution peaks near 0.2 $\mu m^2$. As shown by the comparison between FIG. 1 and FIG. 6, when the area distribution peak is at a large area value, the number of regions including the grain boundary phases 4 decreases accordingly. This is because, during the firing of the aluminum nitride sintered body 1, small grain boundary phases 4 that are widely distributed in a certain region gather together to form a large segregated grain boundary phase 4. When the grain boundary phases 4 are segregated in this manner, the rate of the grain boundary phases 4 appearing on the path of heat conducted through the aluminum nitride sintered body 1 decreases. As a result, the number of areas where phonon scattering occurs frequently in the aluminum nitride sintered body 1 decreases, and the thermal conductivity of the aluminum nitride sintered body 1 improves.

(Embodiment 2)

The constituent features of an aluminum nitride sintered body of Embodiment 2 may be the same as, and/or similar to, those of the aluminum nitride sintered body 1 of Embodiment 1 except for the area distribution of the grain boundary phases 4. That is, the components of the aluminum nitride sintered body in Embodiment 2 may be the same as, and/or similar to, those in Embodiment 1. The minimum thickness of the grain boundary 3x may be 0.2 nm or more and 0.7 nm or less. The thickness of the grain boundary 3x may be 0.2 nm or more and 0.7 nm or less on average.

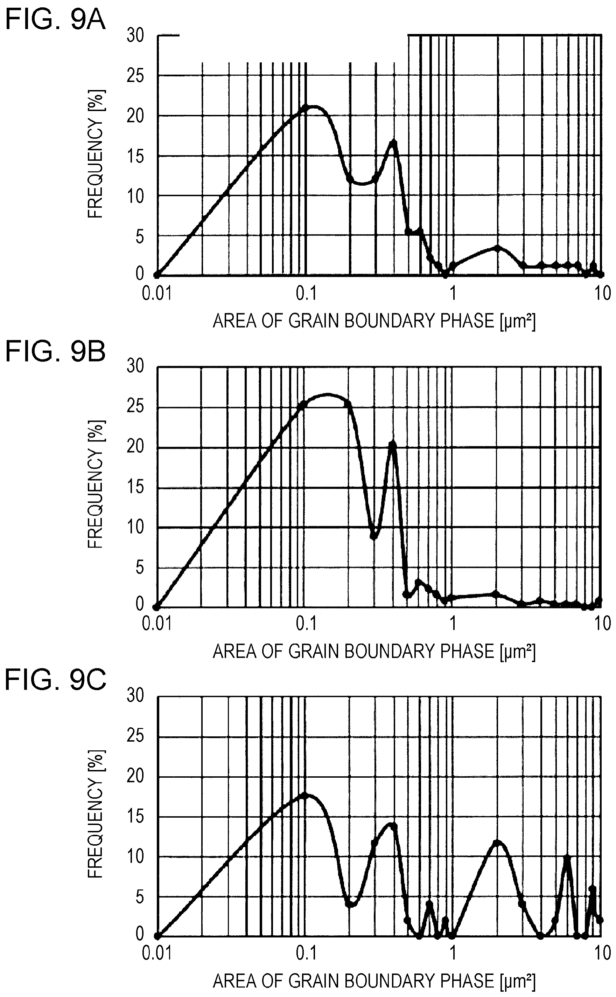

In Embodiment 2, the area distribution peak of the grain boundary phases 4 described above may be located at less than 0.5 $\mu m^2$. FIG. 9A to FIG. 9C illustrate specific examples of area distributions of grain boundary phases determined in three regions of the aluminum nitride sintered body of Embodiment 2. The aluminum nitride sintered body has area distribution peaks at less than 0.5 $\mu m^2$. Even when such area distribution peaks are located, high thermal conductivity of the aluminum nitride sintered body 1 is provided as shown in a specific comparison table given later.

<Thermal Conductivity and Bending Strength>

In the present embodiment, the aluminum nitride sintered body 1 may have a thermal conductivity of 230 W/m·K or more and a bending strength of 350 MPa or more. This configuration can provide a substrate on which an electronic element that generates a large amount of heat is mounted, the substrate satisfying heat dissipation properties that the electronic element requires and mechanical strength to withstand the stress exerted on the substrate. The electronic element may be, for example, a laser oscillator for laser processing. The substrate may be a sub-mount substrate.

The aluminum nitride sintered body 1 may have a thermal conductivity of 235 W/m·K or more and a bending strength of 390 MPa or more. The aluminum nitride sintered body 1 may have a thermal conductivity of 240 W/m·K or more and a bending strength of 430 MPa or more. With these properties, both the heat dissipation properties and the mechanical strength that the substrate on which the electronic element is mounted is required to have can be sufficiently satisfied.

<Comparison of Properties between Present Embodiment and Conventional Aluminum Nitride Sintered Bodies>

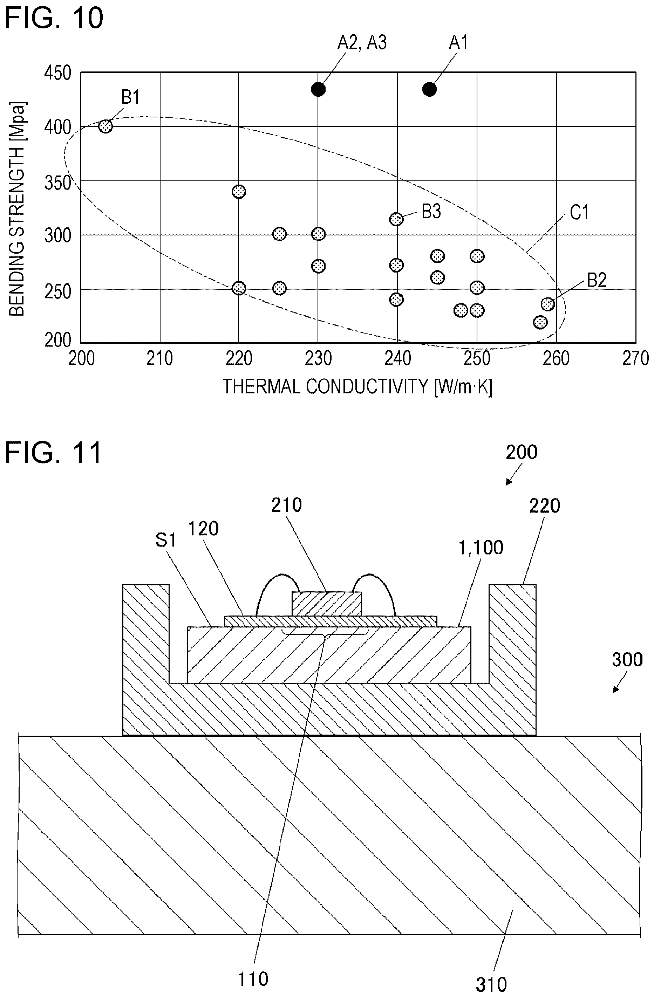

FIG. 10 is a graph showing the thermal conductivity and the bending strength of the aluminum nitride sintered body 1 of the present embodiment and a plurality of aluminum nitride sintered bodies disclosed in Patent Literature 1. In the figure, plots A1 to A3 respectively represent the properties of the aluminum nitride sintered bodies of the present embodiment, that is, the properties of aluminum nitride sintered bodies of Sample Nos. 1 to 3 in the properties table given later. Plot B1 represents the properties of an aluminum nitride sintered body of Sample No. 4 in the properties table given later.

Among the plurality of plots in the graph, plots A1 and A2 are examples of the properties of the aluminum nitride sintered body 1 of Embodiment 1. Plot A3 is an example of the properties of the aluminum nitride sintered body of Embodiment 2. In the aluminum nitride sintered body of plot A1, the minimum thickness of the grain boundary 3x is 0.37 nm, the average thickness of the grain boundary 3x is 0.43 nm, and the area distribution peak of the grain boundary phases 4 is near 2 $\mu m^2$. In the aluminum nitride sintered body of plot A2, the average thickness of the grain boundary 3x is 0.69 nm, and the area distribution peak of the grain boundary phases 4 is near 2.0 $\mu m^2$. In the aluminum nitride sintered body of plot A3, the average thickness of the grain boundary 3x is 0.69 nm, and the area distribution peak of the grain boundary phases 4 is near 0.1 $\mu m^2$. The aluminum nitride sintered body 1 of plot A1 has high thermal conductivity and high bending strength, specifically, a thermal conductivity of 244 W/m·K and a bending strength of 431 MPa. The aluminum nitride sintered bodies of plots A2 and A3 have high thermal conductivity and high bending strength, specifically, a thermal conductivity of 230 W/m·K and a bending strength of 430 MPa.

Plots other than plots A1 to A3 and plot B1 represent the properties of the plurality of aluminum nitride sintered bodies disclosed in Patent Literature 1. Among these plots, plot B1, which has high bending strength (e.g., 400 MPa), has low thermal conductivity (e.g., 203 W/m·K). Plot B2, which has high thermal conductivity (e.g., 259 W/m·K), has low bending strength (e.g., 235 MPa). Plot B3 has a thermal conductivity of 240 W/m·K and a bending strength of 315 MPa.

As shown in the graph of FIG. 10, there is a significant difference between the properties of plots A1 to A3 and the properties of other plots included in region C1 enclosed by a chain line.

The thermal conductivity is determined in accordance with JIS (Japanese Industrial Standards) R1611:2010 using a sample that has a shape of 10 mm × 10 mm × 4 mmt and that has been pretreated such that both surfaces of the sample are subjected to Au (gold) deposition and then coated with a blackening agent.

The bending strength is determined by a three-point bending test in accordance with JIS_R1601:2008 using a sample that has a shape of 4 mm × 40 mm × 3 mmt and that has been pretreated such that main edges of the sample are chamfered.

<Comparison of Properties between Present Embodiments and Aluminum Nitride Sintered Bodies of Comparative Examples>

The following properties table shows the properties of aluminum nitride sintered bodies of Sample Nos. 1 to 9 having different thicknesses (average) of the grain boundary 3 and different degrees of segregation of the grain boundary phases 4.

[Table 1]

| [Properties table] | | | | | | |
|---|---|---|---|---|---|---|
| Sample No. | | Grain boundary thickness (average) [nm] | Area distribution of grain boundary phases [$\mu m^2$] | AlN crystal grain size [$\mu m$] | Thermal conductivity [W/m·K] | Bending strength [MPa] |
| Embodiment | 1 | 0.43 | 2 | 4.6 | 244 | 431 |
| | 2 | 0.69 | 2 | 3.6 | 230 | 430 |
| | 3 | 0.69 | 0.1 | 4.6 | 230 | 430 |
| Comparative Example | 4 | 0.71 | 4 | 2.9 | 203 | 400 |
| | 5 | 0.71 | 0.3 | 4.1 | 170 | 400 |
| | 6 | 0.78 | 2 | 2.0 | 150 | 400 |
| | 7 | 0.82 | 0.2 | 3.7 | 210 | 350 |
| | 8 | 0.53 to 147 | 0.2 | 3.4 | 200 | 200 |
| | 9 | 0.71 | 0.2 | 4.5 | 210 | 350 |

The area distribution in the table indicates an area value at which the frequency of the area distribution peaks. "Grain boundary thickness" of Sample No. 8 means that the average values vary in a wide range from 0.53 to 147 nm.

Sample Nos. 1 and 2 correspond to examples of the aluminum nitride sintered body 1 of Embodiment 1, and Sample No. 3 corresponds to an example of the aluminum nitride sintered body of Embodiment 2. Sample No. 7 corresponds to the aluminum nitride sintered body 81 of Comparative Example 1 described above.

The above properties table shows that there are significant differences in thermal conductivity and bending strength between cases where the thickness of the grain boundary 3 is not more than 0.7 nm and cases where the thickness of the grain boundary 3 is more than 0.7 nm.

<Average Grain Size>

In the aluminum nitride sintered body 1 of the present embodiment, the average grain size of aluminum nitride grains in cross section may be 3 $\mu$m or more and 5 $\mu$m or less.

An aluminum nitride sintered body having an average grain size of more than 5 $\mu$m can be obtained with a high firing temperature and a long firing time. However, a high firing temperature and a long firing time accelerate the growth reaction of aluminum nitride crystals and the redissolution reaction of the aluminum nitride crystals into grain boundary phases. As a result of the acceleration, the corners of aluminum nitride grains are rounded, increasing the likelihood that grain boundary phases are formed between the aluminum nitride grains. Consequently, the degree of segregation of grain boundary phases is likely to decrease.

On the other hand, a small average grain size leads to an increase in the total area of the grain boundary 3 (i.e., the total area of the borders between the plurality of crystal grains 2) in the same volume. The grain boundary 3, when having the above-described minimum thickness or the above-described average thickness, can reduce the thermal conductivity-decreasing effect but cannot completely eliminate the effect. Therefore, the smaller the total area of the grain boundary 3 is, the more the thermal conductivity of the aluminum nitride sintered body 1 can be improved.

Therefore, adopting the above-described average grain size in producing the aluminum nitride sintered body 1 allows the location of the area distribution peak of the grain boundary phases 4 to be easily controlled within the range of Embodiment 1 described above, enabling further improvement of thermal conductivity.

A method of measuring the grain size will be described. In measuring the grain size, first, an SEM image of a cross section of the aluminum nitride sintered body 1 is obtained. Then, line segments of 50 $\mu$m are drawn in the SEM image. The line segments are drawn in three separate areas in the SEM image. Subsequently, the number of grains overlapping the line segments is counted. A grain is counted as one if it overlaps a line segment even partially. Then, the grain size is calculated for each line segment by the following formula (1), and the average of the three grain sizes calculated for the three line segments is determined as the average grain size.

$$\text{Grain size } [\mu m] = 50 \text{ } [\mu m]/\text{number of grains} \cdots (1)$$

<Production Method>

An example of a method for producing an aluminum nitride sintered body of the present embodiment will be described. The thickness of the grain boundary 3 and the degree of segregation of the grain boundary phases 4 can be controlled by changing a plurality of parameters, that is, the amount of sintering aid added, the firing temperature and firing time, and the temperature decrease rate after firing. To obtain an aluminum nitride sintered body, first, a binder and 3.4 mass% of a sintering aid composed mainly of yttrium oxide are added to an AlN raw material in the form of powder particles having an average particle size D50 of 1.96 $\mu$m, and the mixture is formed into a compact in the form of a substrate having an average thickness of 5.53 mm. Subsequently, the compact is debindered and fired in a furnace. The firing is carried out at a firing temperature of 1780°C for a firing time of 30 hours. Subsequently, the compact is cooled such that the temperature decreases at a temperature decrease rate.

The temperature decrease rate is related to the thickness of the grain boundary and the degree of segregation of the grain boundary phases 4. The designer produces a plurality of aluminum nitride sintered bodies at a plurality of temperature decrease rates and measures the thickness of the grain boundary 3 and the degree of segregation of the grain boundary phases 4 for each aluminum nitride sintered body. From the measured values, the designer can determine the relationships between the temperature decrease rate and the thickness of the grain boundary and between the temperature decrease rate and the degree of segregation of the grain boundary phases 4. By selecting an appropriate temperature decrease rate on the basis of the relationships, an aluminum nitride sintered body in which the minimum thickness and the average thickness of the grain boundary 3 are 0.7 nm or less can be produced. In addition, an aluminum nitride sintered body in which the minimum thickness and the average thickness of the grain boundary 3 are 0.7 nm or less and the grain boundary phases 4 are segregated can be produced.

The aluminum nitride sintered body thus produced has a thermal conductivity of 230 W/m·K or more and a bending strength of 350 MPa or more.

<Substrate, Electronic Device, and Electronic Module>

FIG. 11 illustrates a substrate, an electronic device, and an electronic module that are obtained using the aluminum nitride sintered body according to the present embodiment.

In the present embodiment, a substrate 100 is formed by cutting the aluminum nitride sintered body 1 of Embodiment 1 into a rectangular parallelepiped shape with a cutting machine. Instead of the aluminum nitride sintered body 1, the aluminum nitride sintered body of Embodiment 2 may be used. The substrate 100 may be a sub-mount substrate on which an electronic element 210 is mounted and which is mounted on a package 220. A mounting portion 110 for the electronic element 210 is located at a first surface S1 (e.g., an upper surface) of the substrate 100. An electrode 120 is located on the first surface S1 of the substrate 100, and the electronic element 210 may be mounted with the electrode 120 interposed therebetween. Electrodes may be located also on other surfaces of the substrate 100.

In the present embodiment, an electronic device 200 includes the substrate 100, and the electronic element 210 mounted on the mounting portion 110 of the substrate 100. The electronic element 210 may be, for example, a laser oscillator such as a laser diode. The laser oscillator may be an element that outputs a laser for processing in an industrial machine that performs laser processing. Alternatively, the electronic element 210 may be an element that generates heat, such as a power semiconductor.

The electronic device 200 may further include a package 220 on which the substrate 100 is mounted. The package 220 may be made of metal. The package 220 may be configured to enclose the substrate 100 and the electronic element 210. The substrate 100 and the electronic element 210 may be bonded to each other via a bonding material such as solder or brazing filler metal. The substrate 100 and the package 220 may be bonded to each other via a bonding material such as solder or brazing filler metal.

In the present embodiment, an electronic module 300 includes a module substrate 310 and the electronic device 200 mounted on the module substrate 310. In addition to the electronic device 200, various electronic elements, various electrical elements, or both of them may be mounted on the module substrate 310.

According to the substrate 100, the electronic device 200, and the electronic module 300 of the present embodiment, since the aluminum nitride sintered body 1 constituting the substrate 100 has high thermal conductivity, sufficient heat dissipation of the electronic element 210 can be achieved. The aluminum nitride sintered body 1 constituting the substrate 100 further has high mechanical strength. Thus, even when the joint between the electronic element 210 and the substrate 100 or the joint between the substrate 100 and the package 220 is subjected to great stress, the occurrence of damage to the substrate 100 can be reduced.

The embodiments of the present disclosure have been described above. However, the aluminum nitride sintered body, the substrate, the electronic device, and the electronic module according to the present disclosure are not limited to those of the above embodiments, and the details described in the embodiments can be appropriately changed without departing from

the gist of the invention.

The following is an embodiment of the present disclosure. In an embodiment,

(1) an aluminum nitride sintered body includes:

a plurality of crystal grains containing aluminum nitride as a main component,
wherein the plurality of crystal grains includes,

in cross section, a first crystal grain, a second crystal grain adjacent to the first crystal grain, a third crystal grain adjacent to the first crystal grain and the second crystal grain, and a grain boundary located between all or any two of the first crystal grain, the second crystal grain, and the third crystal grain, and
in cross section, the grain boundary has a minimum thickness of 0.2 nm or more and 0.7 nm or less.

(2) In the aluminum nitride sintered body according to (1),
in cross section, the grain boundary has an average thickness of 0.2 nm or more and 0.7 nm or less.
(3) The aluminum nitride sintered body according to (1) or (2) further includes

a plurality of grain boundary phases,
wherein a peak of an area distribution of the grain boundary phases in cross section is located in a range of 0.5 $\mu m^2$ or more.

(4) The aluminum nitride sintered body according to any one of (1) to (3) has

a thermal conductivity of 230 W/m·K or more and a bending strength of 350 MPa or more.
(5) In the aluminum nitride sintered body according to any one of (1) to (4),
the crystal grains have an average grain size in cross section of 3 µm or more and 5 µm or less.
In an embodiment,
(6) a substrate includes:

the aluminum nitride sintered body according to any one of (1) to (5) having a first surface; and
a mounting portion for an electronic element, the mounting portion being located at the first surface.

In an embodiment,
(7) an electronic device includes:

the substrate according to (6); and
an electronic element mounted on the mounting portion.

In an embodiment,
(8) an electronic module includes:

the electronic device according to (7); and
a module substrate on which the electronic device is mounted.

INDUSTRIAL APPLICABILITY

The present disclosure is applicable to an aluminum nitride sintered body, a substrate, an electronic device, and an electronic module.

REFERENCE SIGNS

1 aluminum nitride sintered body
2 crystal grain
2a first crystal grain
2b second crystal grain
2c third crystal grain
3, 3x grain boundary
4 grain boundary phase
100 substrate
110 mounting portion
S1 first surface
120 electrode
200 electronic device
210 electronic element
220 package
300 electronic module
310 module substrate

**Claims**

1.  An aluminum nitride sintered body comprising:

a plurality of crystal grains containing aluminum nitride as a main component,
wherein the plurality of crystal grains comprises,
in cross section, a first crystal grain, a second crystal grain adjacent to the first crystal grain, a third crystal grain adjacent to the first crystal grain and the second crystal grain, and a grain boundary located between all or any two of the first crystal grain, the second crystal grain, and the third crystal grain, and
in cross section, the grain boundary has a minimum thickness of 0.2 nm or more and 0.7 nm or less.

2. The aluminum nitride sintered body according to claim 1,
wherein in cross section, the grain boundary has an average thickness of 0.2 nm or more and 0.7 nm or less.

3. The aluminum nitride sintered body according to claim 1 or 2, further comprising a plurality of grain boundary phases,
wherein a peak of an area distribution of the grain boundary phases in cross section is located in a range of 0.5 $\mu m^2$ or more.

4. The aluminum nitride sintered body according to any one of claims 1 to 3,
having a thermal conductivity of 230 W/m·K or more and a bending strength of 350 MPa or more.

5. The aluminum nitride sintered body according to any one of claims 1 to 4,
wherein the crystal grains have an average grain size in cross section of 3 $\mu m$ or more and 5 $\mu m$ or less.

6. A substrate comprising:

   the aluminum nitride sintered body according to any one of claims 1 to 5 having a first surface; and
   a mounting portion for an electronic element, the mounting portion being located at the first surface.

7. An electronic device comprising:

   the substrate according to claim 6; and
   an electronic element mounted on the mounting portion.

8. An electronic module comprising:

   the electronic device according to claim 7; and
   a module substrate on which the electronic device is mounted.

## FIG. 1

## FIG. 2

FIG. 3A

THICKNESS

FIG. 3B

THICKNESS

## FIG. 4

## FIG. 5

FIG. 6

FIG. 7A

FIG. 7B

FIG. 7C

FIG. 8A

FIG. 8B

FIG. 8C

FIG. 9A

FIG. 9B

FIG. 9C

## FIG. 10

## FIG. 11

## INTERNATIONAL SEARCH REPORT

| International application No. |
|---|
| **PCT/JP2024/011027** |

**A. CLASSIFICATION OF SUBJECT MATTER**

*C04B 35/581*(2006.01)i; *H01L 23/02*(2006.01)i; *H01L 23/13*(2006.01)i
FI: C04B35/581; H01L23/12 C; H01L23/02 F

According to International Patent Classification (IPC) or to both national classification and IPC

**B. FIELDS SEARCHED**

Minimum documentation searched (classification system followed by classification symbols)

C04B35/581; H01L23/02; H01L23/13

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| A | WO 2005/049525 A1 (KABUSHIKI KAISHA TOSHIBA) 02 June 2005 (2005-06-02) claims, p. 6, lines 30-32, table 1 | 1-8 |
| A | JP 2006-1834 A (NGK INSULATORS LTD.) 05 January 2006 (2006-01-05) paragraph [0026] | 1-8 |
| A | JP 1-203270 A (SUMITOMO ELECTRIC INDUSTRIES, LTD.) 16 August 1989 (1989-08-16) claims, p. 3, upper right column, lines 16-18 | 1-8 |
| A | JP 2021-130571 A (KYOCERA CORPORATION) 09 September 2021 (2021-09-09) claims, table 1 | 1-8 |
| A | JP 2020-158375 A (KYOCERA CORPORATION) 01 October 2020 (2020-10-01) claims, table 1 | 1-8 |
| A | JP 2001-89244 A (KYOCERA CORPORATION) 03 April 2001 (2001-04-03) claims, table 1 | 1-8 |

☑ Further documents are listed in the continuation of Box C.      ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **30 April 2024** | **14 May 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT

| International application No. |
|---|
| **PCT/JP2024/011027** |

### C. DOCUMENTS CONSIDERED TO BE RELEVANT

| Category* | Citation of document, with indication, where appropriate, of the relevant passages | Relevant to claim No. |
|---|---|---|
| A | JP 2012-129508 A (TDK CORPORATION) 05 July 2012 (2012-07-05)<br>claims, table 4 | 1-8 |
| A | JP 7-206443 A (HITACHI CHEM CO., LTD.) 08 August 1995 (1995-08-08)<br>claims, table 1 | 1-8 |
| A | CN 110540429 A (NANCHONG THREE-CIRCLE ELECTRONICS CO., LTD.) 06 December 2019 (2019-12-06) | 1-8 |

Form PCT/ISA/210 (second sheet) (July 2022)

**INTERNATIONAL SEARCH REPORT**
Information on patent family members

International application No.

**PCT/JP2024/011027**

| Patent document cited in search report | | | Publication date (day/month/year) | Patent family member(s) | | | Publication date (day/month/year) |
|---|---|---|---|---|---|---|---|
| WO | 2005/049525 | A1 | 02 June 2005 | US claims, paragraph [0032], table 1 CN | 2007/0161495 1882517 | A1 A | |
| JP | 2006-1834 | A | 05 January 2006 | US paragraph [0034] | 2006/0019817 | A1 | |
| JP | 1-203270 | A | 16 August 1989 | US claims, column 4, lines 50-54 | 5034357 | A | |
| JP | 2021-130571 | A | 09 September 2021 | (Family: none) | | | |
| JP | 2020-158375 | A | 01 October 2020 | (Family: none) | | | |
| JP | 2001-89244 | A | 03 April 2001 | (Family: none) | | | |
| JP | 2012-129508 | A | 05 July 2012 | US claims, table 4 | 2012/0162858 | A1 | |
| JP | 7-206443 | A | 08 August 1995 | (Family: none) | | | |
| CN | 110540429 | A | 06 December 2019 | (Family: none) | | | |

Form PCT/ISA/210 (patent family annex) (July 2022)

**EP 4 685 125 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005049525 A